# EUROPÄISCHE PATENTANMELDUNG

(11) **EP 3 700 159 A1**
(43) Veröffentlichungstag der Anmeldung: **26.08.2020**
(21) Anmeldenummer: 19159053.8
(22) Anmeldetag: 25.02.2019
(51) Int. Cl.: H04L 29/06, H03M 7/30, G06N 20/00, H04W 28/06, H04W 28/22

(54) **VERFAHREN UND VORRICHTUNG ZUR BEREITSTELLUNG VON DATEN EINER DATENQUELLE, COMPUTERPROGRAMMPRODUKT UND MASCHINE**

(71) Anmelder: Siemens Aktiengesellschaft, 80333 München (DE)
(72) Erfinder: Schiffler, Andreas, 96472 Rödental (DE); Jäger, Tobias, 91083 Baiersdorf Igelsdorf (DE); Rosenbaum, Björn, 91088 Bubenreuth (DE)

(57) **Zusammenfassung**

Die Erfindung betrifft ein Verfahren und eine Vorrichtung zur Bereitstellung und/oder zur Übertragung von Daten (D) von einer Datenquelle (1) an einen Datenempfänger 3. Die Übertragung der Daten (D) erfolgt mit einer Datenverbindung (5), wobei die Datenverbindung (5) als eine Verbindung zwischen einer ersten Schnittstelle (1a) und einer zweiten Schnittstelle (3a) ausgebildet ist. Die erste Schnittstelle (1a) ist der Datenquelle (1) und die zweite Schnittstelle (3a) ist dem Datenempfänger (3) zugeordnet. Die Datenquelle (1) umfasst ein Komprimierungsmodul (9), wobei die Daten (D) anhand eines Komprimierungsfaktors (KF) soweit komprimiert werden, dass sie durch eine Ist-Datenübertragungsrate (DR_ist) der Datenverbindung (5) übertragen werden können. Mit Hilfe des Verfahrens lassen sich Daten (D) von einer Bearbeitungsmaschine, einer Herstellungsmaschine, einem 3D-Drucker oder einer Automatisierungseinheit an einen dezentralen Server (Cloud) in kontinuierlicher Art und Weise über ein zeitlich verändert belastetes Netzwerk übertragen.

## Beschreibung

Die Erfindung betrifft ein Verfahren und eine Vorrichtung zur Bereitstellung von Daten einer Datenquelle. Weiter betrifft die Erfindung ein Computerprogramm und eine Maschine.

Heute werden in Werkzeugmaschinen eine Vielzahl von unterschiedlichen Daten bereitgestellt. Beispielhaft sind solche Daten Sensordaten, Bilddaten oder Geräuschdaten.

Die Daten werden in der Regel in einer Recheneinheit hinterlegt und/oder ausgewertet, welche nicht Teil der Werkzeugmaschine ist. Demnach werden die Daten mit Hilfe einer Datenverbindung, insbesondere einem Netzwerk, zu einem Datenempfänger, beispielhaft einer Cloud, übertragen.

In der Regel ist das Netzwerk zu unterschiedlichen Zeiten unterschiedlich belastet.

Demnach ist es Aufgabe der Erfindung, die Belastung der Datenverbindung möglichst gering zu halten.

Die Aufgabe wird durch ein Verfahren gemäß Anspruch 1 gelöst. Weiter wird die Aufgabe durch eine Vorrichtung gemäß Anspruch 9 gelöst.

Darüber hinaus wird die Aufgabe mit Hilfe eines Computerprogrammproduktes nach Anspruch 10 sowie durch eine Maschine nach Anspruch 11 gelöst.

Vorteilhafte Ausgestaltungen und Weiterbildungen der Erfindung sind Gegenstand der abhängigen Ansprüche.

Bei dem Verfahren werden Daten von einer Datenquelle über eine erste Schnittstelle an eine Datenverbindung bereitgestellt, umfassend die folgenden Schritte:
- Ermitteln einer Ist-Datenübertragungsrate der Datenverbindung;
- Ermitteln einer benötigten Datenübertragungsrate der Datenverbindung;
- Komprimierung der Daten anhand eines Komprimierungsfaktors, wobei der Komprimierungsfaktor aus der Ist-Datenübertragungsrate und der benötigten Datenübertragungsrate ermittelt wird;
- Bereitstellung der komprimierten Daten.

Die Datenquelle ist vorteilhaft eine Maschine zur Herstellung oder Bearbeitung eines Stückgutes. Darüber hinaus kann die Datenquelle eine Automatisierungseinrichtung sein.

Die Datenverbindung ist vorteilhaft ein Netzwerk, insbesondere ein Netzwerk gemäß einem Industriestandard, beispielhaft PROFI-NET oder ETHER-CAT, oder auch das Internet.

Eine Datenverbindung weist je nach Bandbreite und bereits erfolgendem Datenverkehr eine Ist-Datenübertragungsrate auf. Die Datenübertragungsrate gibt an, welche Datenmenge pro Zeit noch durch die Datenverbindung übertragen werden kann.

Je nach Betriebszustand der Datenquelle soll in der nachfolgenden Zeit eine benötigte Datenübertragungsrate bereitstehen, um alle Daten durch die Datenverbindung an einen Datenempfänger bereit zu stellen.

Da in der Regel die benötigte Datenübertragungsrate kleiner als die Ist-Datenübertragungsrate ist, werden die Daten komprimiert. Da eine Komprimierung mit einem hohen Rechenaufwand verbunden ist und überdies ggf. Verluste bei der Qualität der Daten durch die Komprimierung auftreten, sollte der Komprimierungsfaktor möglichst so gewählt werden, dass die Daten mit der Ist-Datenübertragungsrate übertragbar sind.

Die Ist-Datenübertragungsrate kann die momentan bereitstehende Datenübertragungsrate der Datenverbindung sein. Die Ist-Datenübertragungsrate kann auch eine approximierte Datenübertragungsrate für einen späteren Zeitpunkt sein.

Die Bestimmung der Ist-Datenübertragungsrate erfolgt bei einer bekannten Datenübertragungsrate anhand der verwendeten Komponenten der Datenverbindung und/oder der jeweiligen Schnittstelle.

Bei einer unbekannten Datenübertragungsrate des Netzwerkes kann eine Probe-Übertragung einer Datei mit einer bekannten Größe (z.B. 100 kB) über die Datenverbindung erfolgen, wobei die Zeit für die Übertragung der Datei bestimmt wird. Anhand der Zeit kann die Ist-Datenübertragungsrate der Datenverbindung und/oder der jeweiligen Schnittstelle einfach bestimmt werden.

Zur Bestimmung der benötigten Datenübertragungsrate kann die Datenmenge anhand eines vorliegenden Betriebszustandes der Datenquelle, insbesondere der Maschine, geschätzt werden. Hierbei können die Daten, welche beispielhaft von Sensoren oder von einer Kamera pro Zeiteinheit anfallen, addiert werden.

Die Komprimierung der Daten erfolgt durch bekannte Verfahren wie mp3, mp4, h264 oder JPEG.

Das verwendete Verfahren richtet sich insbesondere nach dem Daten-Typ, wie einer Bild-Datei, einer txt-Datei oder fortlaufenden Filmdaten.

Die Bereitstellung der Daten an die Datenverbindung erfolgt durch eine erste Schnittstelle.

Die erste Schnittstelle ist die Schnittstelle zwischen der Datenquelle und der Datenverbindung.

Durch die variable Daten-Komprimierung können vorteilhaft die gesamten Daten für eine Datenverbindung bereitgestellt werden, wobei gleichzeitig nur eine geringe Rechenleistung bei der Komprimierung der Daten anfällt.

Bei einer vorteilhaften Ausgestaltung der Erfindung wird die Ist-Bandbreite anhand eines lernfähigen Algorithmus ermittelt.

Vorteilhaft wird die Ist-Datenübertragungsrate mit Hilfe eines lernfähigen Algorithmus bestimmt. Der lernfähige Algorithmus kann durch ermittelte Ist-Datenübertragungsraten als Funktion der Zeit angelernt werden.

Vorteilhaft wird die Ist-Datenübertragungsrate und/oder der Komprimierungsfaktor durch den lernfähigen Algorithmus im Voraus ermittelt und einem Modul bereitgestellt, das die Daten entsprechend dem Komprimierungsfaktor oder der Ist-Datenübertragungsrate komprimiert.

Das Modul stellt die komprimierten Daten vorteilhaft der Schnittstelle zur Verfügung.

Durch die Vorbestimmung der Ist-Datenübertragungsrate kann eine Ermittlung der Ist-Datenübertragungsrate vorteilhaft reduziert werden oder ganz entfallen.

Bei einer weiteren vorteilhaften Ausgestaltung der Erfindung wird der lernfähige Algorithmus auf Grundlage einer über die Zeit ermittelten Datenübertragungsrate der Datenverbindung angelernt.

Vorteilhaft wird die Ist-Datenübertragungsrate als Funktion der Zeit ermittelt und als Zeitreihe hinterlegt.

Vorzugsweise erfolgt die Ermittlung der Ist-Datenübertragungsrate als Funktion der Zeit bereits vor der eigentlichen Bereitstellung der Daten an die erste Schnittstelle.

Durch das Anlernen können beispielsweise wiederkehrende Ist-Datenübertragungsraten vorausgesagt werden. Anhand der Voraussagen kann sowohl die Bereitstellung von Daten als auch die Komprimierung der Daten angepasst werden.

Bei einer weiteren vorteilhaften Ausgestaltung der Erfindung sind die Ist-Datenübertragungsrate und/oder der Komprimierungsfaktor als Funktion einer Zeit hinterlegt.

Die Hinterlegung der Ist-Datenübertragungsrate und/oder des Komprimierungsfaktors erfolgt vorzugsweise als Zeitreihe.

Vorteilhaft greift das Modul zur Komprimierung der Daten selbstständig auf die Zeitreihen zu und komprimiert die Daten entsprechend.

Durch die Hinterlegung der Komprimierungsfaktoren und/oder der Ist-Datenübertragungsraten kann die Komprimierung der Daten vereinfacht werden.

Bei einer weiteren vorteilhaften Ausgestaltung der Erfindung erfolgt eine Komprimierung der Daten anhand
- eines den Daten angepassten Komprimierungsalgorithmus und/oder
- eines den Daten angepassten Komprimierungsfaktors.

Je nach Art der Daten kann ein geeigneter Komprimierungsalgorithmus gewählt werden. Beispielhaft werden Bilddateien mit Hilfe einer JPEG-Komprimierung auf eine geringere Größe der Bilddatei komprimiert.

Alternativ kann eine Zeitreihe einer Drehzahl (als Funktion der Zeit) mit Hilfe eines h264-Algorithmus oder eines sonstigen geeigneten Komprimierungsalgorithmus komprimiert werden.

Durch die Wahl eines Komprimierungsalgorithmus, der entsprechend der Art der Daten angepasst ist, kann eine Komprimierung besonders effizient erfolgen.

Eine gleichzeitige Anpassung des Komprimierungsalgorithmus kann dem verwendeten Kompressionsalgorithmus Rechnung tragen. Je nach Effizienz des jeweiligen Kompressionsalgorithmus sowie der Art der zu komprimierenden Daten wird der Komprimierungsalgorithmus vorteilhaft so angepasst, dass die komprimierten Daten derart komprimiert werden, dass die Ist-Datenübertragungsrate gerade ausgenutzt wird.

Durch eine angepasste Wahl des Komprimierungsalgorithmus sowie dem entsprechenden Komprimierungsfaktor kann die Komprimierung der Daten optimal ausgestaltet sein.

Bei einer weiteren vorteilhaften Ausgestaltung der Erfindung umfasst das Verfahren die weiteren Schritte:
- Klassifikation der Daten auf Grundlage der Übertragungswichtigkeit, wobei die Übertragungswichtigkeit den jeweiligen Daten zugeordnet ist;
- Bereitstellung der Daten auf Grundlage der Übertragungsnotwendigkeit.

Die Übertragungswichtigkeit bestimmt vorteilhaft, ob die Daten unmittelbar bereitgestellt werden müssen oder in einem Datenspeicher, welcher der Datenquelle zugeordnet ist, vor der Bereitstellung gespeichert werden können.

Beispielhaft sollten Warn-Signale zeitnah der Schnittstelle bereitgestellt werden, um Schäden an einer Maschine zu verhindern. Alternativ können Bilddateien, die den allgemeinen Zustand der Maschine beschreiben, in einem Zeitbereich übertragen werden, an dem eine Datenübertragungsrate zu erwarten ist.

Durch die Klassifizierung der Daten gemäß Ihrer Wichtigkeit für Ihre Bereitstellung kann die Schnittstelle sowie die Datenverbindung weiter entlastet werden.

Bei einer weiteren vorteilhaften Ausgestaltung werden die bereitgestellten Daten mit Hilfe der Datenverbindung an einen Datenempfänger, insbesondere einen dezentralen Server, übertragen.

Der Datenempfänger ist vorzugsweise als Cloud ausgebildet. Die Übertragung der Daten kann auch über das Internet erfolgen. Der Datenempfänger umfasst vorteilhaft einen Datenspeicher, wobei der Datenspeicher zur Hinterlegung der Daten dient.

Weiter weist der Datenempfänger vorteilhaft eine zweite Schnittstelle auf, wobei die zweite Schnittstelle zum Empfang der Daten ausgebildet ist.

Vorteilhaft kann der Datenempfänger auch Daten für die Datenquelle bereitstellen, so dass die Datenverbindung zu einer bidirektionalen Übertragung von Daten ausgebildet sein kann.

Mit Hilfe der zweiten Schnittstelle und der Datenverbindung werden die Daten, die der ersten Schnittstelle bereitgestellt werden, an den Datenempfänger bereitgestellt.

Durch diese Erweiterung können die bereitgestellten Daten unmittelbar an den Datenempfänger übertragen werden. Somit bildet der Datenempfänger vorteilhaft einen Datenspeicher aus, welcher der Datenquelle zugeordnet ist. Ein Datenspeicher, welcher von der Datenquelle umfasst wird, kann entsprechend kleiner ausgebildet werden.

Bei einer weiteren vorteilhaften Ausgestaltung der Erfindung werden die Daten im Datenempfänger dekomprimiert werden und die dekomprimierten Daten auf einem Datenspeicher abgespeichert werden.

Der Datenspeicher ist bei dieser Ausgestaltung dem Datenempfänger, insbesondere als Cloud-Speicher, zugeordnet. Für eine verbesserte Bearbeitung der Daten in dem Datenempfänger werden die Daten dekomprimiert und in dem Datenspeicher des Datenempfängers hinterlegt.

Alternativ können die Daten auch komprimiert auf dem Datenspeicher hinterlegt werden, um den dort benötigten Speicherplatz zu verringern.

Durch die Hinterlegung der Daten auf dem Datenspeicher des Datenempfängers kann ein Datenspeicher, der unmittelbar der Datenquelle zugeordnet ist, kleiner ausgebildet sein.

Die Vorrichtung zur Bereitstellung von Daten einer Datenquelle umfasst eine erste Schnittstelle zur Verbindung der Vorrichtung mit einer Datenverbindung und ein Kompressionsmodul, weiter optional eine Datenverbindung und einen Datenempfänger, wobei die Vorrichtung zur Ausführung des vorstehend ausgeführten Verfahrens ausgebildet ist.

Die Datenverbindung dient zur datentechnischen Verbindung von der Datenquelle und dem Datenempfänger. Die Datenverbindung verbindet hierbei die erste Schnittstelle mit der zweiten Schnittstelle. Die erste Schnittstelle ist der Datenquelle zugeordnet und die zweite Schnittstelle ist dem Datenempfänger zugeordnet. Die Schnittstelle kann als Netzwerkadapter ausgebildet sein.

Die Datenquelle umfasst ein Modul zur Komprimierung der Daten. Das Modul ist vorteilhaft als Softwaremodul ausgebildet. Die Datenquelle weist vorteilhaft eine Recheneinheit auf, wobei die Recheneinheit das Modul zur Komprimierung der Daten umfasst. Darüber hinaus dient die Recheneinheit zum Ablauf und/oder zum Anlernen des lernfähigen Algorithmus.

Der Datenempfänger umfasst vorteilhaft eine Recheneinheit, wobei die Recheneinheit zur Dekomprimierung der Daten ausgebildet ist. Der Datenempfänger umfasst vorteilhaft den Datenspeicher zum Hinterlegen der Daten, welche die erste Schnittstelle bereitstellt.

Die Daten können Sensordaten als Funktion der Zeit sein. Die Sensordaten sind vorteilhaft als Zeitreihen hinterlegbar. Beispielhaft sind die Sensordaten: eine Temperatur, eine Drehzahl, ein Drehmoment, ein Maß für eine Vibration, oder eine Frequenz.

Alternativ oder zusätzlich können die Daten auch Bilddateien umfassen. Beispielhaft können die Bilddateien durch optische Sensoren wie eine CCD-Kamera oder eine Video-Kamera bereitgestellt werden.

Vorzugsweise werden die Zeitreihen in einem Datenspeicher zwischengespeichert und dann komprimiert und der ersten Schnittstelle bereitgestellt.

Eine hier beschriebene Vorrichtung eignet sich vorzugsweise zur vorausschauenden Wartung, wobei Sensoren einer Maschine Daten aufnehmen, diese an eine Cloud übertragen. Die Daten werden auf der Cloud ausgewertet. Damit eine kontinuierliche Datenübertragung bei gleichzeitig nur geringer Belastung einer Recheneinheit der Datenquelle erfolgen kann, erfolgt eine dynamische Komprimierung der Daten auf Grundlage einer voraussichtlich bereitstehenden Datenübertragungsrate der Datenverbindung.

Das Computerprogrammprodukt ist zum Ablauf auf einer Recheneinheit ausgebildet, wobei das Computerprogrammprodukt zur Bereitstellung von Daten für eine Datenverbindung und einen Datenempfänger ausgebildet ist, wobei das Computerprogramm zur Durchführung eines Verfahrens gemäß der vorstehenden Beschreibung ausgebildet ist.

Das Computerprogrammprodukt ist vorzugsweise auf einem Datenspeicher hinterlegt und wird vorteilhaft auf einer Recheneinheit ausgeführt, welche der Datenquelle zugeordnet wird.

Das Computerprogrammprodukt umfasst vorteilhaft das Modul zur Komprimierung der Daten. Das Computerprogrammprodukt umfasst darüber hinaus vorteilhaft den lernfähigen Algorithmus.

Das Computerprogramm dient, insofern es auf der Recheneinheit abläuft, zur Komprimierung der Daten und zur Bereitstellung der komprimierten Daten an die erste Schnittstelle.

Das Computerprogramm kann auch zur Bestimmung einer Ist-Datenübertragungsrate dienen, wobei die Datenübertragungsrate auch mit Hilfe der ersten und/oder der zweiten Schnittstelle bestimmbar ist.

Die Maschine ist insbesondere als Verarbeitungsmaschine, als Bearbeitungsmaschine, als Herstellungsmaschine oder als Automatisierungsvorrichtung ausgebildet und umfasst eine Vorrichtung gemäß der vorangehenden Beschreibung.

Bevorzugt ist die Maschine als 3D-Drucker ausgebildet. Die Maschine umfasst jeweils zumindest einen Sensor. Der zumindest eine Sensor dient vorteilhaft zur Bereitstellung der Daten. Die Daten werden vorteilhaft in dynamischer Art und Weise komprimiert und der ersten Schnittstelle bereitgestellt.

Im Folgenden wird die Erfindung anhand von Figuren näher beschrieben und erläutert. Die in den Figuren gezeigten Ausführungsformen sind lediglich beispielhaft.

Es zeigen
- FIG 1: eine beispielhafte Vorrichtung,
- FIG 2: eine weitere beispielhafte Vorrichtung,
- FIG 3: eine beispielhafte Datenübertragungsrate sowie
- FIG 4: ein beispielhaftes Verfahren.

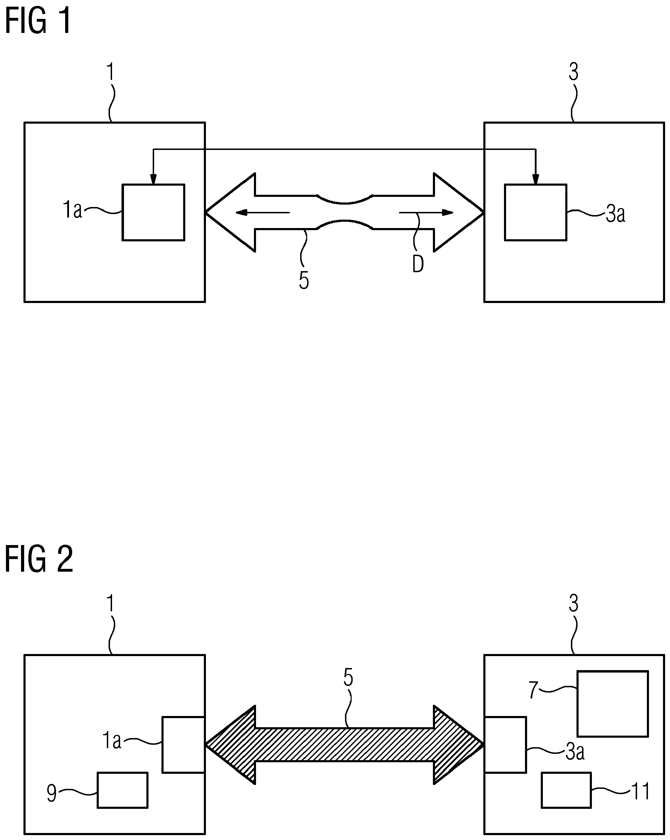

**FIG 1** zeigt eine beispielhafte Vorrichtung. Die Vorrichtung umfasst eine Datenquelle 1, beispielsweise eine Bearbeitungsmaschine. Die Vorrichtung umfasst weiter einen Datenempfänger 3. Die Datenquelle 1 kann eine Bearbeitungsmaschine, insbesondere eine Werkzeugmaschine, sein.

Die Datenquelle 1 und der Datenempfänger 3 tauschen Daten D mit Hilfe einer Datenverbindung 5 aus. Die Datenverbindung 5 ist vorteilhaft als Netzwerk ausgebildet. Die Datenverbindung 5 ist in der Regel mit einer begrenzten Ist-Datenübertragungsrate DR_ist ausgebildet. Dies ist durch die Verengung in der Mitte der als Doppelpfeil symbolisierten Datenverbindung 5 dargestellt.

Die Datenquelle 1 weist eine erste Schnittstelle 1a auf. Die Schnittstelle 1a dient zur Bereitstellung der Daten D von der Datenquelle 1 an die Datenverbindung 5. Der Datenempfänger 3 weist eine zweite Schnittstelle 3a auf. Die zweite Schnittstelle 3a dient zum Empfang der bereitgestellten Daten D.

Der doppelt ausgebildete Pfeil zwischen der ersten Schnittstelle 1a und der zweiten Schnittstelle 3a soll die Übermittlung der Ist-Datenübertragungsrate DR_ist an die zumindest erste Schnittstelle 1a symbolisieren. Anhand der Ist-Datenübertragungsrate DR_ist wird vorteilhaft der Komprimierungsfaktor KF für die Daten D bestimmt.

Die erste Schnittstelle 1a und die zweite Schnittstelle 3a sind vorteilhaft datentechnisch verbunden. Vorteilhaft wird die Ist-Datenübertragungsrate DR_ist der Datenverbindung 5 von der jeweiligen Schnittstelle 1a, 3a an die jeweils andere Schnittstelle 1a, 3a bereitgestellt.

Anhand der Ist-Datenübertragungsrate DR_ist der Datenverbindung 5 erfolgt eine Komprimierung der Daten D, insbesondere mit Hilfe eines Komprimierungsmoduls 9. Auf Grundlage der Ist-Datenübertragungsrate DR_ist der Datenverbindung 5 erfolgt eine Komprimierung auf Grundlage eines variablen Komprimierungsfaktors KF. Der Komprimierungsfaktor KF wird vorteilhaft anhand der Ist-Datenübertragungsrate DR_ist der Datenverbindung 5 sowie der benötigten Datenübertragungsrate DR_soll ermittelt.

**FIG 2** zeigt eine weitere beispielhafte Vorrichtung. Die Vorrichtung dient zur Bereitstellung von Daten D von einer Datenquelle 1 zu einem Datenempfänger 3.

Die Daten D werden über eine Datenverbindung 5, insbesondere über das Netzwerk, von der Datenquelle 1 zum Datenempfänger 3 übertragen. Vorteilhaft ist eine Rückübertragung von Daten D mit Hilfe der Datenverbindung 5 ebenfalls möglich.

Die Daten D werden von einer ersten Schnittstelle 1a für die Datenverbindung 5 bereitgestellt. Die Datenverbindung 5 stellt die Daten D an eine zweite Schnittstelle 3a bereit, wobei die zweite Schnittstelle 3a dem Datenempfänger 3 zugeordnet ist. Die Schnittstellen 1a, 3a sind vorzugsweise als Netzwerk-Adapter ausgebildet.

Die Daten werden im Datenempfänger 3 vorteilhaft auf einem Datenspeicher 7 hinterlegt. Der Datenempfänger 3 ist vorteilhaft als dezentraler Server, insbesondere als Cloud-Speicher, ausgebildet.

Die Datenquelle 1 weist ein Komprimierungsmodul 9 auf. Der Datenempfänger 3 weist ein Dekomprimierungsmodul 11 auf. Die Daten D werden vorteilhaft mit Hilfe des Komprimierungsmoduls 9 komprimiert. Die komprimierten Daten werden über die Datenverbindung 5 dem Datenempfänger 3 bereitgestellt. Die komprimierten Daten D werden im Datenempfänger 3 wieder mit Hilfe des Dekomprimierungsmoduls 11 dekomprimiert und gegebenenfalls auf dem Datenspeicher 7 hinterlegt.

Die Komprimierung erfolgt auf Grundlage bekannter Komprimierungsalgorithmen wie mp3, mp4, h264, JPEG.

Eine Festlegung des Komprimierungsfaktors KF erfolgt auf Grundlage der Ist-Datenübertragungsrate DR_ist der Datenverbindung 5.

Die benötigte Datenübertragungsrate DR-soll ist vorzugsweise mit Hilfe der jeweiligen Schnittstelle 1a, 3a ermittelbar.

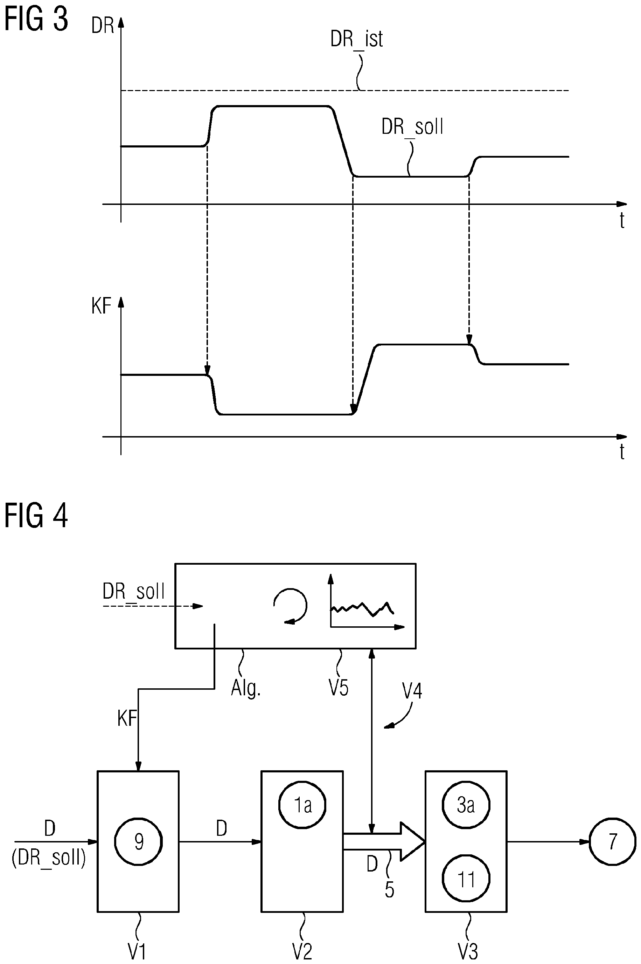

**FIG 3** zeigt eine beispielhafte Datenübertragungsrate DR. Der obere Teil der Figur zeigt den zeitlichen Verlauf der Ist-Übertragungsrate DR_ist als Funktion der Zeit t (als durchgezogene Linie dargestellt). Weiter zeigt der obere Teil der Figur die benötigte Datenübertragungsrate DR_soll (gestrichelt dargestellt) als Funktion der Zeit t. Die benötigte Datenübertragungsrate DR-soll ist hier als konstant über die Zeit t angenommen.

Die Ist-Datenübertragungsrate DR_ist ist hier als die Datenmenge pro Zeiteinheit definiert, welche durch die Datenverbindung 5 in Verbindung mit der jeweiligen Schnittstelle 1a, 3a übertragbar ist.

Im unteren Teil der Figur ist der Komprimierungsfaktor KF als Funktion der Zeit t angegeben. Der Komprimierungsfaktor KF entspricht im Wesentlichen dem Verhältnis von der benötigten Datenübertragungsrate DR_soll zur Ist-Datenübertragungsrate DR_ist.

Wenn die Ist-Datenübertragungsrate DR_ist der Datenverbindung 5 abnimmt, so steigt der Komprimierungsfaktor KF an. Eine Änderung der Ist-Datenübertragungsrate DR_ist wird durch die gestrichelt gezeichneten, vertikalen Pfeile symbolisch darstellt. Ein Anstieg des Komprimierungsfaktors KF bedeutet, dass eine stärkere Komprimierung der Daten D erfolgt, welche an die Datenverbindung 5 bereitgestellt werden.

**FIG 4** zeigt ein beispielhaftes Verfahren. Das Verfahren umfasst die folgenden Schritte:
In einem ersten Schritt V1 werden die Daten D einem Modul 9 zur Komprimierung der Daten D bereitgestellt. Die Daten D werden mit einer benötigten Datenübertragungsrate DR_soll an das Modul 9 bereitgestellt. Mit Hilfe des Moduls 9 werden die Daten D anhand eines Komprimierungsfaktors KF komprimiert.

In einem zweiten Schritt V2 werden die komprimierten Daten D durch die erste Schnittstelle 1a an die Datenverbindung 5 bereitgestellt. Die Daten D werden mit Hilfe der Datenverbindung 5 einem Datenempfänger 3 bereitgestellt.

In einem dritten Schritt V3 werden die Daten D von der zweiten Schnittstelle 3a in Empfang genommen. Die Daten D können mit einem Dekomprimierungsmodul 11 wieder dekomprimiert werden. Die empfangenen Daten D oder die dekomprimierten Daten D können in einem Datenspeicher 7 des Datenempfängers 3 hinterlegt werden. Von/auf dem Datenspeicher 7 können die Daten D verarbeitet oder analysiert werden.

In einem vierten Schritt wird die Ist-Datenübertragungsrate DR-ist der Datenverbindung 5 und/oder der jeweiligen Schnittstelle 1a, 3a bestimmt. Die Ist-Datenübertragungsrate DR_ist kann als Funktion der Zeit t hinterlegt werden.

Anhand des zeitlichen Verlaufes der Ist-Datenübertragungsrate DR_ist kann in einem fünften Schritt V5 ein lernfähiger Algorithmus Alg eine Schätzung einer voraussichtlichen Ist-Datenübertragungsrate DR_ist als Funktion der Zeit t bereitstellen. Anhand einer optional bereitgestellten benötigten Datenübertragungsrate DR_soll stellt der lernfähige Algorithmus Alg den Komprimierungsfaktor KF an das Kompressionsmodul 9 bereit.

Vorteilhaft wird der lernfähige Algorithmus anhand der gemessenen Ist-Datenübertragungsrate als Funktion der Zeit t angelernt. Ein gut angelernter selbstlernender Algorithmus ist vorzugsweise in der Lage, einen Komprimierungsfaktor als Funktion der Zeit bereitzustellen, ohne dass eine andauernde Bestimmung der Ist-Datenübertragungsrate DR_ist erfolgen muss.

Zusammenfassend betrifft die Erfindung ein Verfahren und eine Vorrichtung zur Bereitstellung und/oder zur Übertragung von Daten D von einer Datenquelle 1 an einen Datenempfänger 3. Die Übertragung der Daten D erfolgt mit einer Datenverbindung 5, wobei die Datenverbindung 5 als eine Verbindung zwischen einer ersten Schnittstelle 1a und einer zweiten Schnittstelle 3a ausgebildet ist. Die erste Schnittstelle 1a ist der Datenquelle 1 und die zweite Schnittstelle 3a ist dem Datenempfänger 3 zugeordnet. Die Datenquelle 1 umfasst ein Komprimierungsmodul 9, wobei die Daten D anhand eines Komprimierungsfaktors KF soweit komprimiert werden, dass sie durch eine Ist-Datenübertragungsrate der Datenverbindung 5 übertragen werden können. Mit Hilfe des Verfahrens lassen sich Daten D von einer Bearbeitungsmaschine, einer Herstellungsmaschine, einem 3D-Drucker oder einer Automatisierungseinheit an einen dezentralen Server (Cloud) in kontinuierlicher Art und Weise über ein zeitlich verändert belastetes Netzwerk übertragen.

## Patentansprüche

1. Verfahren, wobei Daten (D) von einer Datenquelle (1), insbesondere einer Maschine, über eine erste Schnittstelle (1a) an eine Datenverbindung (5) bereitgestellt werden, umfassend die folgenden Schritte:
- Ermitteln einer Ist-Datenübertragungsrate (DR_ist) der Datenverbindung (5);
- Ermitteln einer benötigten Datenübertragungsrate (DR_soll) der Datenverbindung (5);
- Komprimierung der Daten (D) anhand eines Komprimierungsfaktors (KF), wobei der Komprimierungsfaktor (KF) aus der Ist-Datenübertragungsrate (KF_ist) und der benötigten Datenübertragungsrate (DR_soll) ermittelt wird;
- Bereitstellung der komprimierten Daten (D).

2. Verfahren nach Anspruch 1, wobei die Ist-Datenübertragungsrate (DR_ist) anhand eines lernfähigen Algorithmus (Alg) ermittelt wird.

3. Verfahren nach Anspruch 2, wobei der lernfähige Algorithmus (Alg) auf Grundlage einer über die Zeit (t) ermittelten Ist-Datenübertragungsrate (DR_ist) der Datenverbindung (5) angelernt wird.

4. Verfahren nach einem der vorangehenden Ansprüche, wobei die Datenübertragungsrate (DR_ist) und/oder der Komprimierungsfaktor (KF) als Funktion einer Zeit (t) hinterlegt sind.

5. Verfahren nach einem der vorangehenden Ansprüche, wobei eine Komprimierung der Daten (D) anhand
- eines den Daten (D) angepassten Komprimierungsalgorithmus und/oder
- eines den Daten (D) angepassten Komprimierungsfaktors (KF)
erfolgt.

6. Verfahren nach einem der vorangehenden Ansprüche, umfassend die weiteren Schritte:
- Klassifikation der Daten (D) auf Grundlage der Übertragungswichtigkeit, wobei die Übertragungswichtigkeit den jeweiligen Daten (D) zugeordnet ist;
- Bereitstellung der Daten (D) auf Grundlage der Übertragungsnotwendigkeit.

7. Verfahren nach einem der vorangehenden Ansprüche, wobei die bereitgestellten Daten (D) mit Hilfe der Datenverbindung (5) an einen Datenempfänger (3), insbesondere einen dezentralen Server, übertragen werden.

8. Verfahren nach einem der vorangehenden Ansprüche, wobei die Daten (D) im Datenempfänger (3) dekomprimiert werden und die dekomprimierten Daten auf einem Datenspeicher (7) hinterlegt werden.

9. Vorrichtung zur Bereitstellung von Daten einer Datenquelle, umfassend eine Schnittstelle (1a) zur Verbindung der Vorrichtung mit einer Datenverbindung (5) und ein Kompressionsmodul (9), weiter optional eine Datenverbindung (5) und einen Datenempfänger (3), wobei die Vorrichtung zur Ausführung eines Verfahrens nach einem der vorangehenden Ansprüche ausgebildet ist.

10. Computerprogrammprodukt zum Ablauf auf einer Recheneinheit, wobei das Computerprogrammprodukt zur Bereitstellung von Daten (D) für eine Datenverbindung (5) und einen Datenempfänger (3) ausgebildet ist, wobei das Computerprogramm zur Durchführung eines Verfahrens nach einem der Ansprüche 1 bis 9 vorgesehen ist.

11. Maschine, insbesondere als Verarbeitungsmaschine, Bearbeitungsmaschine, Herstellungsmaschine oder Automatisierungsvorrichtung ausgebildet, umfassend eine Vorrichtung nach Anspruch 9.
